# FASCICULE DE BREVET EUROPEEN

(11) **EP 3 669 013 B1**
(45) Date de publication et mention de la délivrance du brevet: **11.08.2021**
(21) Numéro de dépôt: 18789201.3
(22) Date de dépôt: 25.09.2018
(51) Int. Cl.: C23C 14/08, C23C 14/34, C23C 14/35, C23C 14/58, H01M 8/1246

(54) **PROCÉDÉ DE FABRICATION PAR PULVÉRISATION CATHODIQUE MAGNÉTRON D'UN ÉLECTROLYTE POUR CELLULES ÉLECTROCHIMIQUES À OXYDE SOLIDE**
VERFAHREN ZUR HERSTELLUNG EINES ELEKTROLYTEN FÜR FESTOXIDZELLEN DURCH MAGNETRON-KATHODEN-SPUTTERING
METHOD FOR MANUFACTURING AN ELECTROLYTE FOR SOLID OXIDE CELLS BY MAGNETRON CATHODE SPUTTERING

(30) Priorité: 26.09.2017 FR 1758902
(43) Date de publication de la demande: 24.06.2020
(73) Titulaire: Commissariat à l'Energie Atomique et aux Energies Alternatives, 75015 Paris (FR); Centre National de la Recherche Scientifique, 75794 Paris Cedex 16 (FR); Université d'Orléans, 45100 Orléans (FR)
(72) Inventeur: VULLIET, Julien, 37170 Chambray-Les-Tours (FR); THOMANN, Anne-Lise, 45240 Menestreau-En-Villette (FR); CODDET, Pierre-Laurent, 45160 Olivet (FR)
(74) Mandataire: Brevalex
(86) Numéro de dépôt international: PCT/FR2018/052360
(87) Numéro de publication internationale: WO 2019/063934

(56) Documents cités:
- US-A1- 2016 351 752
- PEDERSON L R ET AL: "Application of vacuum deposition methods to solid oxide fuel cells", VACUUM, PERGAMON PRESS, GB, vol. 80, no. 10, 3 août 2006 (2006-08-03), pages 1066-1083, XP025009751, ISSN: 0042-207X, DOI: 10.1016/J.VACUUM.2006.01.072 [extrait le 2006-08-03]
- H. HIDALGO ET AL: "Optimization of DC Reactive Magnetron Sputtering Deposition Process for Efficient YSZ Electrolyte Thin Film SOFC", FUEL CELLS, vol. 13, no. 2, 1 avril 2013 (2013-04-01), pages 279-288, XP055482065, DE ISSN: 1615-6846, DOI: 10.1002/fuce.201200125

## Description

### DOMAINE TECHNIQUE

L'invention se rapporte au domaine des systèmes électrochimiques producteurs d'énergie ou d'hydrogène.

Plus spécifiquement, l'invention se rapporte à un procédé qui permet de fabriquer par pulvérisation cathodique magnétron un électrolyte sous la forme d'un film mince, dense et stable, propre à entrer dans la constitution de cellules électrochimiques dites à oxyde solide (ou SOC pour « **S**olide **O**xide **C**ells ») dont font partie les cellules électrochimiques pour pile à combustible à oxyde solide (ou SOFC pour « **S**olid **O**xide **F**uel **C**ells ») et les cellules électrochimiques pour électrolyseurs haute température (ou SOEC pour « **S**olid **O**xyde **E**lectrolyser **C**ells »).

### ÉTAT DE LA TECHNIQUE ANTÉRIEURE

Les SOFC sont des cellules électrochimiques productrices d'énergie électrique et thermique qui utilisent l'énergie chimique générée par la réaction de formation d'eau à partir de l'hydrogène et de l'oxygène.

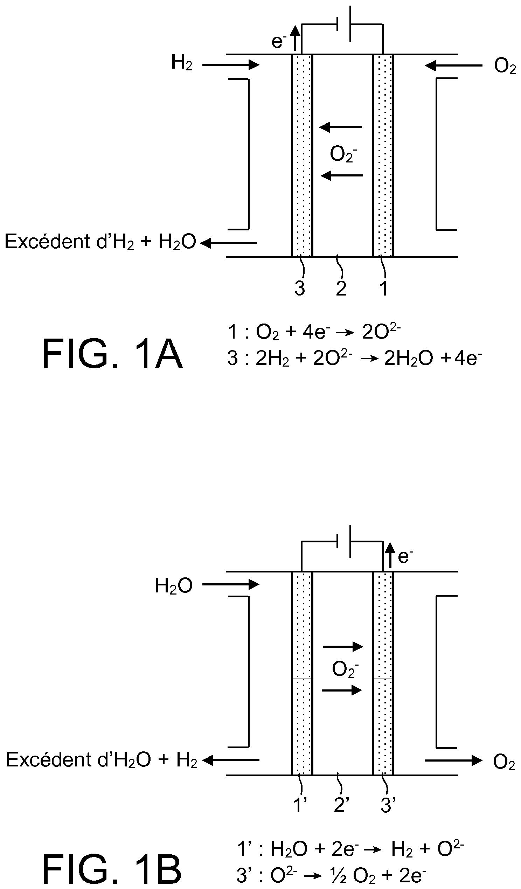

Comme visible sur la figure 1A jointe en annexe, le principe de fonctionnement d'une cellule SOFC est basé sur le mécanisme suivant : l'oxygène de l'air, qui est apporté à la cathode 1, est dissocié pour donner des anions O²⁻. Les anions ainsi formés migrent à travers l'électrolyte 2 jusqu'à atteindre l'anode 3 au niveau de laquelle ils oxydent les atomes d'hydrogène qui sont apportés par le combustible. Cette réaction libère des électrons et de l'eau.

Les SOEC sont des cellules électrochimiques productrices, elles, d'hydrogène dont le principe de fonctionnement est strictement inverse à celui des SOFC.

En effet, comme visible sur la figure 1B jointe en annexe, dans le cas d'une cellule SOEC, de la vapeur d'eau est apportée à la cathode 1' et les molécules d'eau sont dissociées en hydrogène et en anions O²⁻. Les anions ainsi formés diffusent à travers l'électrolyte 2' pour se recombiner sous forme d'oxygène à l'anode 3' tandis que l'hydrogène reste, avec la vapeur d'eau, à la cathode. Cet hydrogène peut ensuite être récupéré pour être utilisé comme combustible dans d'autres applications.

Pour fabriquer de telles cellules électrochimiques, l'obtention d'électrolytes se présentant sous la forme de films minces et denses (pour être étanches aux gaz) est nécessaire. Plus un électrolyte répond à ces critères, plus la chute ohmique dans l'électrolyte est faible et plus la tension à l'abandon de la cellule électrochimique est élevée. Cela permet, dans les deux cas, d'augmenter les performances électrochimiques globales.

Le matériau d'électrolyte actuellement le plus utilisé est la zircone stabilisée à l'yttrine (ou YSZ pour « **Y**ttria-**S**tabilised **Z**irconia »).

L'élaboration d'électrolytes sous la forme de films minces, et en particulier de films minces d'YSZ, par pulvérisation cathodique magnétron - qui est une technique connue pour permettre des dépôts de quelques µm d'épaisseur - a donné lieu à un certain nombre de travaux, et ce, aussi bien en courant continu (cf., par exemple, E.S. Thiele et al., Journal of Vacuum Science and Technology A 9(6), 1991, 3054-3060, ci-après référence **[1]** ; A.F. Jankowski et J.P. Hayes, Surface and Coatings Technology, 76-77, 1995, 126-131, ci-après référence **[2]**) qu'en radiofréquence (cf., par exemple, R.W. Knoll et E.R. Bradley, Thin Solid Films 117, 1984, 201-210, ci-après référence **[3]** ; A.L. Shaula et al., Vacuum 83, 2009, 1266-1269, ci-après référence **[4]**).

On rappelle que le principe de la pulvérisation cathodique (ou « sputtering » en anglais) est l'éjection d'atomes ou molécules d'une cible sous l'effet du bombardement par des ions créés dans un plasma gazeux et accélérés dans un champ électrique. Les atomes du matériau cible, ayant ou non réagi avec un gaz réactif associé au gaz plasmagène, se déposent sur un substrat placé en vis-à-vis de la cible. La pulvérisation cathodique magnétron est une version de cette technique dans laquelle un ensemble d'aimants (ou magnétron) est ajouté derrière la cible permettant d'augmenter la vitesse de dépôt par confinement du plasma.

Lorsque le dépôt d'un matériau, tel qu'un oxyde, se fait à partir d'une cible métallique dans un plasma composé d'un gaz plasmagène et d'un gaz réactif (O₂ pour un oxyde), on parle de pulvérisation réactive.

Dans ce cas, deux modes de fonctionnement existent selon la proportion du gaz réactif par rapport au gaz plasmagène : un mode dit de « pulvérisation élémentaire », ou « mode métal », à faible proportion de gaz réactif, qui se traduit par un dépôt métallique, et un mode dit de « pulvérisation du composé », ou « mode composé », à forte proportion de gaz réactif, qui se traduit par un dépôt du composé le plus stable issu de la réaction entre le gaz réactif et le métal constituant la cible. La transition d'un mode à l'autre se fait à un certain débit du gaz réactif qui dépend des caractéristiques de la chambre de pulvérisation (dimensions, volume, .....), du système de pompage dont est munie cette chambre et des conditions de pulvérisation. Cette transition présente une hystérésis, c'est-à-dire que le passage du « mode métal » au « mode composé » ne se produit pas au même débit de gaz réactif que celle du « mode composé » au « mode métal ». Certains dispositifs de pulvérisation magnétron, qui sont équipés de systèmes de contrôle de la phase gazeuse (par exemple, par spectroscopie d'émission optique) ou des caractéristiques de la décharge (comme la tension de cathode), et d'une boucle de régulation, permettent toutefois un fonctionnement dans un mode de pulvérisation intermédiaire. Dans ce cas, les dépôts sont partiellement oxydés.

Le mode de pulvérisation du composé est, en général, peu utilisé pour l'élaboration de films d'épaisseur supérieure à 1 micromètre en raison de sa faible vitesse de dépôt et des contraintes importantes provoquées par l'accumulation de défauts dans les couches obtenues.

Les modes de pulvérisation élémentaire et de transition, qui ont une vitesse de dépôt d'un ordre supérieur, lui sont donc généralement préférés. Dans ces modes, le film formé sur le substrat contient le précurseur métallique de la cible et une proportion d'oxygène qui varie en fonction des conditions de pulvérisation et du débit du gaz réactif, mais qui reste inférieure à la proportion stoechiométrique obtenue en mode de pulvérisation du composé.

En particulier, le mode de pulvérisation élémentaire permet d'obtenir des films relativement denses à une vitesse de dépôt compatible avec les contraintes industrielles. Cependant, il est nécessaire de soumettre ensuite ces films à un traitement thermique sous air pour, d'une part, permettre une réaction du matériau constituant ces films (déficitaire en oxygène) avec l'oxygène de l'air, (cf. P. Plantin et al., Surface & Coatings Technology 200, 2005, 408-412, ci-après référence **[5]**) et, d'autre part, améliorer leur qualité cristalline.

Or, l'application d'un traitement thermique à des films d'une épaisseur relativement importante (c'est-à-dire, de 1 µm à 10 µm dans le cas d'un film d'électrolyte pour SOC) conduit à des fractures de stress et à une délamination des films si ces films sont denses. À titre d'exemple, le taux d'expansion volumique (ou facteur de Pilling et Bedworth) est de 1,57 pour le passage du zirconium à de la zircone (cf. N.D. Pilling et R.E. Bedworth, Journal Institute of Metals 29, 1923, 529, ci-après référence **[6]**) et proche de 1,45 pour une zircone stabilisée à l'yttrium avec une proportion massique de 15 % d'yttrium (cf. Y.I. Park et al., in: S.C. Singhal, M. Dokiya (EDs.), ECS Proc. SOFC VIII, 7, 2003, 169, ci-après référence **[7]**). Cette expansion volumique conduit à une augmentation de l'épaisseur des films, augmentation qui est, par exemple, proche de 30 % pour des films de La-Si-O (cf. C.Y. Ma et al., Ionics 14, 2008, 471, ci-après référence **[8]**).

Pour pallier ces inconvénients, il est possible de réduire l'épaisseur des films afin de limiter les risques de délamination. Une autre solution consiste à modifier les paramètres d'élaboration des films de sorte à fabriquer des films moins denses qui supporteront l'expansion volumique induite par le traitement thermique. Dans ce cas, le but est de transformer des films relativement peu denses après leur dépôt en films présentant une densité supérieure après le traitement thermique et, donc, une bonne imperméabilité aux gaz qui sont utilisés dans les SOC (cf. P. Coddet et al., Fuel Cells 11(2), 2011, 158-164, ci-après référence **[9]**). Toutefois, la gestion délicate de cette expansion volumique conduit à une étanchéité aux gaz des films qui est insuffisante pour le fonctionnement d'une SOC.

Par ailleurs, les autres techniques de dépôt de couches minces, telles que les techniques de sérigraphie, de dépôt chimique en phase vapeur (ou CVD) et de dépôt par couche atomique (ou ALD), ne sont pas adaptées à la réalisation de films présentant à la fois l'épaisseur et la densité requises pour des films d'électrolyte pour SOC.

Un autre procédé de fabrication d'un film électrolyte pour SOC est connu de H. HIDALGO ET AL: "Optimization of DC Reactive Magnetron Sputtering Déposition Process for Efficient YSZ Electrolyte Thin Film SOFC", FUEL CELLS, vol. 13, no. 2,1 avril 2013 (2013-04-01), pages 279-288 ci-après référence **[10]**.

Compte-tenu de ce qui précède, les Inventeurs se sont donc fixé pour but de fournir un procédé qui permette de fabriquer des films d'électrolytes pour SOC et qui soit, d'une manière générale, exempt des inconvénients présentés par les procédés proposés à ce jour.

Plus spécifiquement, ils se sont fixé pour but que ce procédé permette de fabriquer des films d'électrolytes pour SOC qui répondent aux exigences d'épaisseur et de densité (et, donc, d'étanchéité aux gaz) requises pour ce type de cellules électrochimiques, et ce, sans risque de fractures de stress ou de délamination.

Ils se sont de plus fixé pour but que ce procédé soit facilement adaptable à la nature et au comportement des matériaux utilisés pour la fabrication des films d'électrolytes pour SOC.

Ils se sont de plus fixé pour but que ce procédé soit compatible avec les contraintes des Industriels en termes de coûts et de délais de sorte à pouvoir être mis en œuvre pour la fabrication de SOC à une échelle industrielle.

### EXPOSÉ DE L'INVENTION

Tous ces buts sont atteints par l'invention qui propose un procédé de fabrication d'un électrolyte sous la forme d'un film pour cellules électrochimiques à oxyde solide, caractérisé en ce qu'il comprend les étapes consistant à :
- chauffer un substrat à une température allant de 200 °C à 1 200 °C ; puis
- soumettre le substrat à au moins deux cycles de traitement, chaque cycle de traitement comprenant :
   1) un dépôt d'une couche d'un précurseur métallique sur le substrat par pulvérisation cathodique magnétron d'une cible constituée du précurseur métallique, la pulvérisation étant réalisée dans des conditions de pulvérisation élémentaire ; puis
   2) une oxydation-cristallisation du précurseur métallique formant la couche déposée sur le substrat en présence d'oxygène pour obtenir la transformation du précurseur métallique en le matériau d'électrolyte ;
et en ce que le substrat est maintenu à une température allant de 200 °C à 1200 °C pendant toute la durée de chaque cycle de traitement.

Dans ce qui suit, les expressions « de .... à .... », « allant de .... à .... » et « compris(e) entre .... et .... » sont équivalentes et entendent signifier que les bornes sont incluses.

Par ailleurs, les termes « conditions de pulvérisation élémentaire » sont pris dans leur acceptation habituelle dans le domaine de la pulvérisation cathodique réactive, à savoir qu'il s'agit de conditions dans lesquelles la pulvérisation se traduit par un dépôt métallique. Ces conditions sont obtenues pour un débit de gaz réactif se situant au-dessous d'une valeur critique, laquelle peut aisément être déterminée en établissant, pour la chambre de pulvérisation cathodique dans laquelle on entend réaliser la pulvérisation, la courbe d'hystérésis. Cette courbe peut être établie en étudiant l'évolution d'un paramètre électrique tel que la tension ou la puissance au niveau de la cible, ou l'évolution de la pression régnant dans la chambre de pulvérisation cathodique en fonction du débit de gaz réactif, dans les conditions opératoires choisies pour mettre en œuvre la pulvérisation.

Conformément à l'invention, le substrat est, de préférence, chauffé et maintenu à une température allant de 450 °C à 850 °C pendant toute la durée de chaque cycle de traitement.

Selon un premier mode de mise en œuvre du procédé de l'invention, chaque cycle de traitement est réalisé dans une chambre de pulvérisation cathodique magnétron dans laquelle se trouvent le substrat chauffé et la cible et dans laquelle règne une pression, auquel cas chaque cycle de traitement comprend les étapes consistant à :
- alimenter la chambre de pulvérisation en un gaz plasmagène à un débit D_{P}1 ;
- ajuster la pression régnant dans la chambre de pulvérisation à une valeur allant de 0,1 Pa à 10 Pa et, de préférence, de 0,2 Pa à 2 Pa ;
- débuter la pulvérisation de la cible ;
- alimenter la chambre de pulvérisation en oxygène à un débit D_{R}1 inférieur au débit D_{P}1 tout en maintenant la pression régnant dans la chambre de pulvérisation à la valeur allant de 0,1 Pa à 10 Pa pour créer des conditions de pulvérisation élémentaire ;
- maintenir les conditions de pulvérisation élémentaire pendant un temps suffisant pour obtenir la formation de la couche du précurseur métallique sur le substrat ;
- arrêter la pulvérisation de la cible ;
- augmenter le débit D_{R}1 pour obtenir un débit d'alimentation de la chambre de pulvérisation en oxygène D_{R}2, arrêter l'alimentation de la chambre de pulvérisation en gaz plasmagène ou réduire le débit D_{P}1 pour obtenir un débit d'alimentation de la chambre de pulvérisation en gaz plasmagène D_{P}2 au plus égal à 1/2 de D_{R}2 et, de préférence, au plus égal à 1/10^{ème} de D_{R}2, et ajuster la pression régnant dans la chambre de pulvérisation à une valeur au moins égale à 10 Pa et, de préférence, allant de 10 Pa à 500 Pa, pour créer des conditions d'oxydation-cristallisation du précurseur métallique formant la couche déposée sur le substrat ;
- maintenir les conditions d'oxydation-cristallisation pendant un temps suffisant pour obtenir la transformation du précurseur métallique formant la couche déposée sur le substrat en le matériau d'électrolyte par oxydation-cristallisation du précurseur métallique ; et
- arrêter l'alimentation de la chambre de pulvérisation en oxygène.

Dans ce premier mode de mise en œuvre :
* le substrat est avantageusement maintenu à une température constante pendant toute la durée de chaque cycle de traitement, laquelle température est, de préférence, comprise entre 450 °C et 850 °C ;
* le débit D_{P}1 est, de préférence, compris entre 1 sccm (de « **S**tandard **C**ubic **C**entimeter per **M**inute ») et 500 sccm et, mieux encore, entre 5 sccm et 50 sccm ;
* le débit D_{R}1 est, de préférence, au plus égal à 100 sccm et, mieux encore, au plus égal à 10 sccm, tandis que le débit D_{R}2 est, lui, de préférence compris entre 10 sccm à 500 sccm et, mieux encore, entre 20 sccm et 200 sccm, étant entendu que, comme précédemment précisé, D_{R}1 doit être inférieur à D_{P}1 tandis que D_{R}2 doit être supérieur à D_{R}1.

Par ailleurs, les conditions de pulvérisation élémentaire sont, de préférence, maintenues durant 1 minute à 120 minutes et, mieux encore, durant 10 minutes à 60 minutes, tandis que les conditions d'oxydation-cristallisation sont, de préférence, maintenues durant 1 minute à 60 minutes et, mieux encore, durant 1 minute à 5 minutes.

Selon un deuxième mode de mise en œuvre du procédé de l'invention, chaque cycle de traitement est réalisé dans deux chambres différentes, le dépôt étant réalisé dans une première chambre qui est une chambre de pulvérisation cathodique magnétron dans laquelle règnent des conditions de pulvérisation élémentaire, et l'oxydation-cristallisation étant réalisée dans une deuxième chambre dans laquelle règnent des conditions d'oxydation-cristallisation, auquel cas chaque cycle de traitement comprend de plus, entre le dépôt et l'oxydation-cristallisation, le transfert du substrat de la première chambre à la deuxième chambre.

Dans ce deuxième mode de mise en œuvre :
- les conditions de pulvérisation élémentaire sont une pression régnant dans la première chambre comprise entre 0,1 Pa et 10 Pa et, de préférence, entre 0,2 Pa et 2 Pa, une alimentation de la première chambre en un gaz plasmagène à un débit D_{P}1 et une alimentation de la première chambre en oxygène à un débit D_{R}1 inférieur au débit D_{P}1; tandis que
- les conditions d'oxydation-cristallisation sont une pression régnant dans la deuxième chambre au moins égale à 10 Pa et, de préférence, comprise entre 10 Pa et 500 Pa, une alimentation de la deuxième chambre en oxygène à un débit D_{R}2 supérieur au débit D_{R}1, et éventuellement une alimentation de la deuxième chambre en gaz plasmagène à un débit D_{P}2 au plus égal à 1/2 de D_{R}2 et, de préférence, au plus égal à 1/10^{ème} de D_{R}2.

Là également, le débit D_{P}1 est, de préférence, compris entre 1 sccm et 500 sccm et, mieux encore, entre 5 sccm et 50 sccm ; le débit D_{R}1 est, de préférence, au plus égal à 100 sccm et, mieux encore, au plus égal à 10 sccm, tandis que le débit D_{R}2 est, lui, de préférence compris entre 10 sccm à 500 sccm et, mieux encore, entre 20 sccm et 200 sccm, étant entendu que, comme précédemment précisé, D_{R}1 doit être inférieur à D_{P}1 tandis que D_{R}2 doit être supérieur à D_{R}1.

Par ailleurs, le substrat est, de préférence, maintenu dans la première chambre durant 1 minute à 120 minutes et, mieux encore, durant 10 minutes à 60 minutes, tandis que le substrat est, de préférence, maintenu dans la deuxième chambre durant 1 minute à 60 minutes et, mieux encore, durant 1 minute à 5 minutes.

Dans le deuxième mode de mise en œuvre, il est possible de n'utiliser que deux chambres différentes, l'une dédiée au dépôt des couches du précurseur métallique et l'autre dédiée à l'oxydation-cristallisation du précurseur métallique formant ces couches, auquel cas chaque cycle de traitement à l'exception du dernier cycle comprend de plus, à l'issue de l'oxydation-cristallisation, le transfert du substrat de la deuxième chambre à la première chambre. Ainsi, il peut notamment s'agir de deux chambres qui sont reliées l'une à l'autre par une canne de transfert permettant le transfert du substrat d'une chambre à l'autre mais qui sont séparées l'une de l'autre par un sas permettant de maintenir constantes les conditions de température, de pression et d'atmosphère régnant dans chaque chambre et dans lequel transite le substrat au cours de son transfert d'une chambre à l'autre.

Il est également possible d'utiliser un dispositif de traitement au défilé comprenant une succession de chambres différentes, dont une sur deux est dédiée au dépôt des couches du précurseur métallique et une sur deux est dédiée à l'oxydation-cristallisation du précurseur métallique formant ces couches. Là également, ces différentes chambres peuvent reliées les unes aux autres par un jeu de cannes de transfert tout en étant séparées les unes des autres par des sas.

Ce deuxième mode de mise en œuvre peut être particulièrement intéressant, notamment pour une mise en œuvre à une échelle industrielle, parce que :
- il offre la possibilité d'utiliser des températures différentes pour le dépôt et pour l'oxydation-cristallisation, étant entendu que ces températures doivent être comprises entre 200 °C et 1200 °C et sont préférentiellement comprises entre 450 °C et 850 °C ;
- il permet de supprimer les temps d'attente qu'imposent la montée et la descente en pression ainsi que l'ajustement des débits de gaz plasmagène et de gaz réactif qui sont nécessaires à l'instauration des conditions de pulvérisation élémentaire et d'oxydation-cristallisation dans le cas de l'utilisation d'une chambre unique ;
- il permet d'éviter que les conditions de température, de pression et d'atmosphère dans lesquelles est réalisée l'oxydation-cristallisation n'affectent la cible, notamment par oxydation ; et
- il offre la possibilité de soumettre en parallèle des substrats à un dépôt et des substrats à une oxydation-cristallisation dans le cas d'un traitement au défilé.

Quel que soit le mode de mise en œuvre, le procédé de l'invention comprend, de préférence, de 2 à 20 et, mieux encore, de 2 à 5 cycles de traitement.

Conformément à l'invention, le matériau d'électrolyte peut être tout matériau dont l'utilisation a été proposée pour la réalisation d'électrolytes pour SOC tel qu'un mélange d'oxydes de formule MO₂-M'O₃ où M représente le zirconium ou le cérium tandis que M' représente l'yttrium, le scandium ou un élément du groupe des lanthanides, une cérine de formule Ce₁₋ₓMₓO_{2-δ} dans laquelle M représente le samarium, le gadolinium ou l'yttrium, un oxyde de structure pérovskite basé sur LaGaO₃ et dans lequel le lanthane peut être partiellement substitué par le strontium, le calcium ou le baryum tandis que le gallium peut être partiellement substitué par le magnésium et/ou le cobalt ou le fer, ou une apatite de formule La₁₀₋ₓMₓ(Si_{1-y}M'_{y}O₄)₆O_{2±δ} dans laquelle M représente le strontium, le calcium ou le baryum tandis que M' représente l'aluminium, le germanium ou le magnésium.

Toutefois, on préfère que ce matériau soit un mélange d'oxydes de formule MO₂-M'O₃ où M représente le zirconium ou le cérium et M' représente l'yttrium, le scandium ou un élément du groupe des lanthanides et, plus encore, une zircone stabilisée à l'yttrine.

De ce fait, la cible est, de préférence, une cible comprenant un mélange M-M' dans lequel M représente le zirconium ou le cérium et M' représente l'yttrium, le scandium ou un lanthanide, et, plus encore, un mélange de zirconium et d'yttrium, par exemple dans un rapport massique de 82/18.

Le gaz plasmagène est typiquement un gaz neutre, de préférence l'argon.

Quant au substrat, il peut être constitué d'un film d'un matériau d'électrode (positive ou négative) pour SOC, lui-même disposé sur un film d'un matériau d'interconnexion pour SOC.

Outre les avantages précités, le procédé de l'invention comprend encore d'autres avantages dont ceux :
- de permettre de réaliser le dépôt des couches du précurseur métallique à une vitesse élevée (>250 nm/h) et d'obtenir des couches d'épaisseur inférieure à 2-3 µm ;
- de permettre, par une mesure de la pression régnant dans la chambre dans laquelle est réalisée l'oxydation-cristallisation, un suivi du degré d'oxydation du précurseur métallique et, partant, d'optimiser ce degré d'oxydation en jouant sur la durée de cette étape ;
- d'éviter le recours à un traitement thermique ultérieur qui peut conduire à une délamination et à une fissuration des films liée au stress ;
- de conduire à des films qui présentent un taux de fuite du même ordre de grandeur que celui de films 4 fois plus épais, fabriqués de manière conventionnelle (cf. II.2 ci-après) ;
- de pouvoir être mis en œuvre sur un seul site et au moyen d'un seul équipement, ce qui limite la manipulation des films ; et
- de pouvoir être intégré dans un procédé de fabrication de cellules électrochimiques SOC par pulvérisation cathodique magnétron.

D'autres caractéristiques et avantages de l'invention ressortiront du complément de description qui suit et qui se réfère aux figures annexées.

Bien entendu, ce complément de description n'est donné qu'à titre d'illustration de l'objet de l'invention et ne constitue en aucun cas une limitation de cet objet.

### BRÈVE DESCRIPTION DES FIGURES

La figure 1A, déjà commentée, illustre schématiquement le principe de fonctionnement d'une SOFC.
La figure 1B, déjà commentée, illustre schématiquement le principe de fonctionnement d'une SOEC.

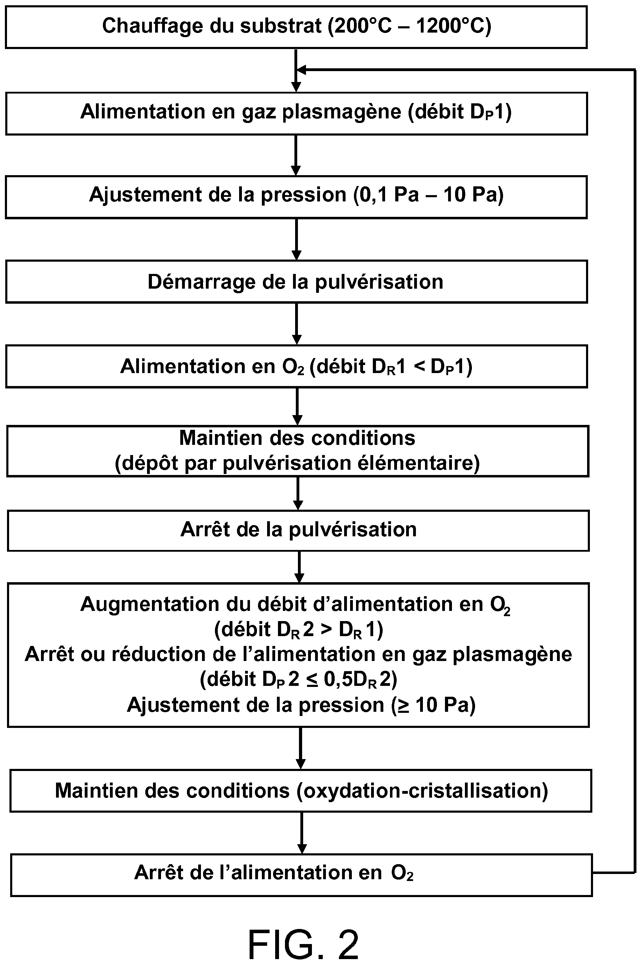

La figure 2 représente schématiquement un mode de mise en œuvre du procédé de l'invention dans lequel chaque cycle de traitement est réalisé dans une seule chambre qui est une pulvérisation magnétron.

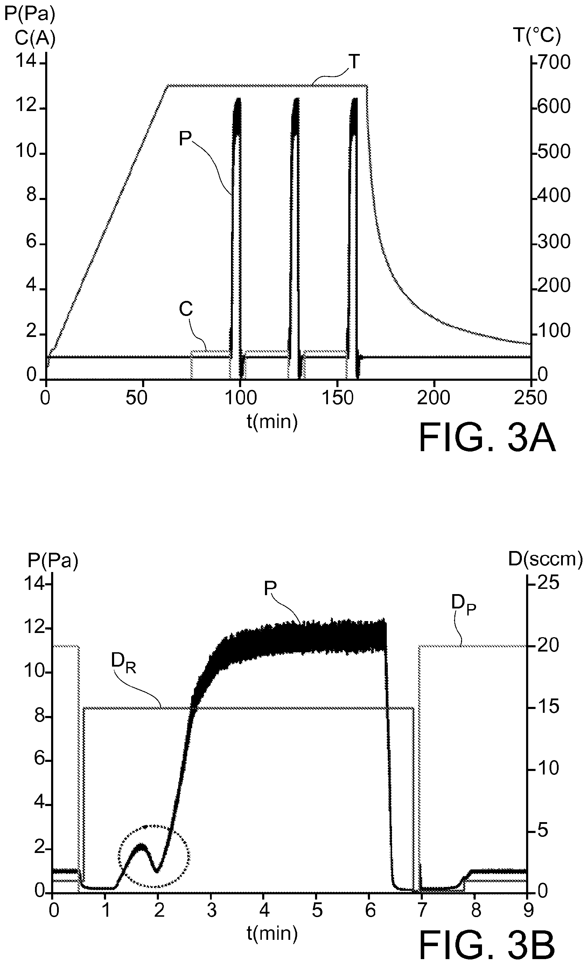

La figure 3A illustre les courbes de pression (courbe P), de courant (courbe C) et de température (courbe T) en fonction du temps, noté t et exprimé en min, telles que relevées lors de la mise en œuvre du procédé de l'invention selon le mode illustré sur la figure 2 ; sur cette figure, les valeurs de pression, notée P et exprimée en Pa, et les valeurs de courant, noté C et exprimé en A, sont indiquées sur l'axe des ordonnées de gauche tandis que les valeurs de température, notée T et exprimée en °C, sont indiquées sur l'axe des ordonnées de droite.
La figure 3B est un agrandissement de la partie située entre les pointillés sur la figure 3A ; sur cette figure, sont représentées les courbes de pression (courbe P), de débit d'argon (courbe D_{P}) et de débit d'oxygène (courbe D_{R}) en fonction du temps, noté t et exprimé en min, telles que relevées sur cette zone ; sur cette figure, les valeurs de pression, notée P et exprimée en Pa, sont indiquées sur l'axe des ordonnées de gauche tandis que les valeurs de débit, noté D et exprimé en sccm, sont indiquées sur l'axe des ordonnées de droite.

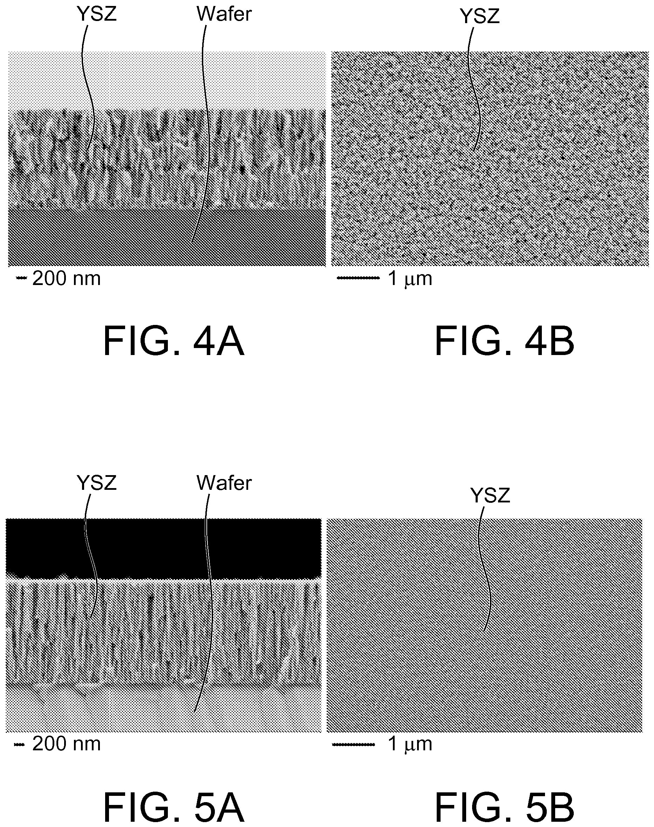

Les figures 4A et 4B sont des images prises au microscope électronique à balayage (ou MEB), à deux grandissements différents, d'un film d'YSZ fabriqué par le procédé de l'invention sur un wafer de silicium, la figure 4A étant une image du film vu en coupe transversale et la figure 4B étant une image du film vu de dessus.
Les figures 5A et 5B sont des images prises au MEB, à deux grandissements différents, d'un film d'YSZ réalisé par un dépôt conventionnel par pulvérisation magnétron sur un wafer de silicium, la figure 5A étant une image du film vu en coupe transversale et la figure 5B étant une image du film vu de dessus.

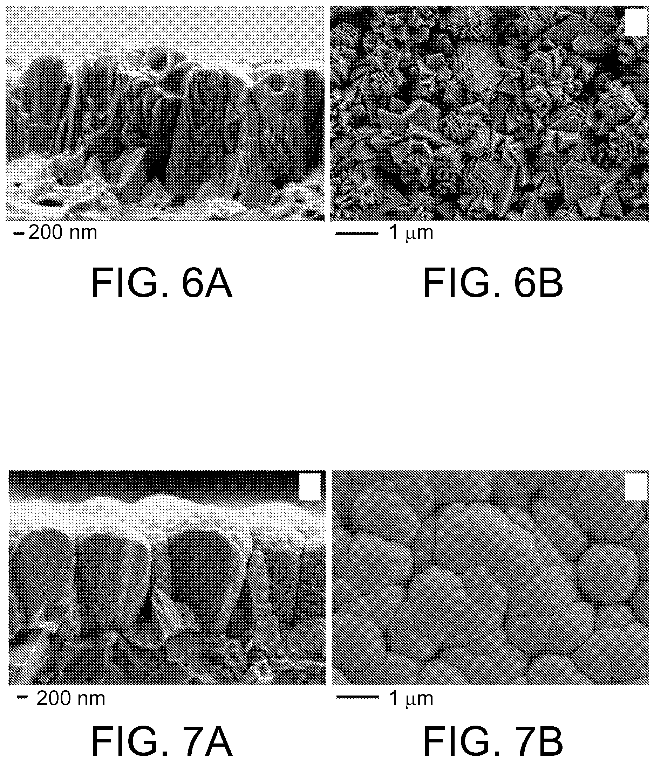

Les figures 6A et 6B sont des images prises au MEB, à deux grandissements différents, d'un film d'YSZ fabriqué par le procédé de l'invention sur un film d'un matériau d'électrode poreux NiO-YSZ, la figure 6A étant une image du film vu en coupe transversale et la figure 6B étant une image du film vu de dessus.
Les figures 7A et 7B sont des images prises au MEB, à deux grandissements différents, d'un film d'YSZ réalisé par un dépôt conventionnel par pulvérisation magnétron sur un film d'un matériau d'électrode poreux NiO-YSZ, la figure 7A étant une image du film vu en coupe transversale et la figure 7B étant une image du film vu de dessus.

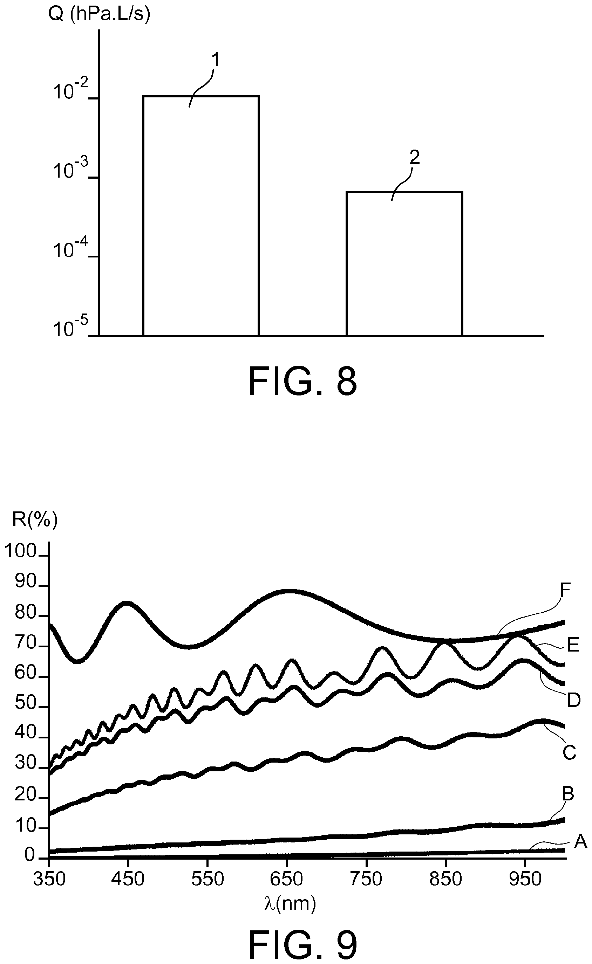

La figure 8 illustre sous la forme d'un diagramme en bâtons le taux de fuite, noté Q et exprimé en hPa.L/s, tel qu'obtenu dans un test de perméabilité à l'azote pour un film d'YSZ fabriqué par le procédé de l'invention (bâton de droite) et pour un film d'YSZ de même épaisseur réalisé par un dépôt conventionnel par pulvérisation magnétron (bâton de gauche).
La figure 9 illustre la transmission optique, notée R et exprimée en %, pour une longueur d'onde, notée λ et allant de 350 nm à 1000 nm, telle qu'obtenue pour des films d'YSZ fabriqués par le procédé de l'invention (courbes C, D et E), pour un film d'YSZ réalisé par un dépôt conventionnel par pulvérisation magnétron (courbe A), pour un film préparé par un procédé ne comprenant qu'un cycle de traitement (courbe B) et pour un film d'YSZ totalement oxydé (courbe F).

### EXPOSÉ DÉTAILLÉ DE MODES DE RÉALISATION PARTICULIERS

### I - SCHÉMA DE PRINCIPE D'UN MODE DE MISE EN ŒUVRE

On se réfère à la figure 2 qui illustre schématiquement un mode de mise en œuvre du procédé selon l'invention dans lequel chaque cycle de traitement auquel est soumis le substrat est réalisé dans la chambre de pulvérisation d'une machine de dépôt PVD par pulvérisation cathodique magnétron.

Comme visible sur cette figure, la première étape du procédé consiste à chauffer le substrat, préalablement fixé sur le porte-substrat de la chambre de pulvérisation, pour amener la température de ce substrat à une température allant de 200 °C à 1200 °C et, de préférence, de 450 °C à 850 °C. Ce chauffage peut, être par exemple, réalisé au moyen d'un module de chauffage dont est équipée la chambre de pulvérisation.

Une fois la température du substrat désirée atteinte, commence alors le premier cycle de traitement du substrat avec successivement et dans cet ordre :
a) l'alimentation de la chambre de pulvérisation en un gaz plasmagène à un débit D_{P}1, le gaz plasmagène étant typiquement un gaz neutre, de préférence l'argon, et le débit D_{P}1 étant, de préférence, compris entre 1 sccm et 500 sccm et, mieux encore, entre 5 sccm et 50 sccm ;
b) l'ajustement de la pression régnant dans la chambre de pulvérisation à une valeur allant de 0,1 Pa à 10 Pa, cet ajustement étant réalisé au moyen du système de pompage dont est équipée la chambre de pulvérisation ;
c) le démarrage de la pulvérisation de la cible constituée du précurseur métallique devant être déposé sur le substrat par démarrage du générateur électrique associé à la cible ;
d) l'alimentation de la chambre en oxygène à un débit D_{R}1 inférieur au débit D_{P}1, le débit D_{R}1 étant, de préférence, au plus égal à 100 sccm et, mieux encore, au plus égal à 10 sccm, tout en maintenant la pression régnant dans la chambre à la valeur à laquelle elle a été ajustée à l'étape b), de sorte à instaurer dans la chambre de pulvérisation des conditions de pulvérisation élémentaire ;
e) le maintien des conditions de pulvérisation élémentaire pendant un temps suffisant pour obtenir la formation de la couche du précurseur métallique sur le substrat, ce temps pouvant aller de 1 min à 120 min en fonction de la nature du précurseur métallique et de l'épaisseur de la couche que l'on souhaite déposer;
f) l'arrêt de la pulvérisation de la cible ;
g) l'augmentation du débit d'alimentation D_{R}1 de la chambre de pulvérisation en oxygène - ce débit étant, de préférence, porté à une valeur D_{R}2 allant de 10 sccm à 500 sccm et, mieux encore, allant de 20 sccm à 200 sccm -, l'arrêt de l'alimentation de la chambre de pulvérisation en gaz plasmagène ou la réduction du débit D_{P}1 pour obtenir un débit d'alimentation de la chambre de pulvérisation en gaz plasmagène D_{P}2 au plus égal à la moitié de D_{R}2 et, de préférence, au plus égal au dizième de D_{R}2, et l'ajustement de la pression régnant dans la chambre de pulvérisation à une valeur au moins égale à 10 Pa, typiquement de 10 Pa à 500 Pa, pour créer des conditions d'oxydation-cristallisation du précurseur métallique formant la couche déposée sur le substrat, l'ajustement de la pression étant réalisé par réduction, voire l'arrêt du pompage ;
h) le maintien des conditions d'oxydation-cristallisation pendant un temps suffisant pour transformer le précurseur métallique formant la couche déposée sur le substrat en le matériau d'électrolyte par oxydation-cristallisation du précurseur métallique, ce temps pouvant aller de 1 min à 60 min ; et
i) l'arrêt de l'alimentation de la chambre de pulvérisation en oxygène.

Après un temps d'attente, typiquement, de 30 s à 600 s, pour permettre une désoxydation de la cible, le substrat est soumis à un nouveau cycle de traitement identique à celui qui vient d'être décrit, et ce, une ou plusieurs fois, de préférence, de 1 à 20 fois selon l'épaisseur que doit présenter au final le film d'électrolyte, cette épaisseur allant typiquement de 1 µm à 10 µm, et/ou selon la stoechiométrie en oxygène ou le degré d'oxydation-cristallisation que l'on souhaite conférer à ce film (cf. point II.2 ci-après).

Comme connu en soi, un cache de protection est avantageusement disposé entre la cible et le substrat afin de protéger ce substrat pendant toutes les étapes autres que l'étape de dépôt de la couche du matériau précurseur sur le substrat, c'est-à-dire l'étape e) de chaque cycle.

### II - VALIDATION EXPÉRIMENTALE

### II.1 - Fabrication de films d'YSZ :

Des films d'YSZ sont fabriqués en appliquant le mode de mise en œuvre décrit au point I ci-avant dans une enceinte de pulvérisation magnétron d'un volume de 35 litres (APRIM VIDE COMPANY) équipée d'un magnétron de 4 pouces, d'un générateur pulsé Pinnacle™ + (ADVANCED ENERGY) et d'une cible métallique composée de zirconium et d'yttrium dans un rapport massique de 82/18 et de pureté égale à 99,9 %.

L'enceinte est connectée *via* une vanne à tiroir (HVA) à un système de pompage composé d'une pompe sèche XDS-5 (EDWARDS Limited) et d'une pompe turbo-moléculaire ATH 400M (ADIXEN).

Les débits de gaz sont contrôlés par des régulateurs de débit massiques (BRONKHORST) et la pression régnant dans l'enceinte de pulvérisation est mesurée par une jauge combinée Pirani/cathode froide (ALCATEL ACC 1009) et une jauge capacitive (PFEIFFER CCR 375).

Les substrats utilisés sont, d'une part, des wafers de silicium et, d'autre part, des films d'un matériau d'électrode poreux qui sont des films d'un cermet de nickel et de zircone dopée à l'yttrine (ou NiO-YSZ) fabriqués de manière conventionnelle par coulage en bande et sérigraphie.

Chacun de ces substrats est soumis à 3 cycles de traitement en utilisant les conditions suivantes :
- Pour le dépôt des couches de ZrY (étape e) :
   Température au niveau du porte substrat : 550 °C ± 10 °C
   Distance entre la cible et le substrat : 127 mm
   Intensité du courant de décharge sur la cible : 1,25 A
   Tension de la décharge sur la cible : - 205 V - - 160 V
   Puises : 5 µs à 50 kHz
   Débit d'argon (D_{P}1) : 20 sccm
   Débit d'oxygène (D_{R}1) : 1 sccm
   Pression régnant dans l'enceinte : 1 Pa
   Temps de dépôt : 20 min pour chaque couche, soit un temps de dépôt cumulé de 60 min pour les 3 couches
- Pour l'oxydation-cristallisation des couches de ZrY (étape h) :
   Température au niveau du porte substrat : 550 °C ± 10 °C
   Débit d'argon : 0 sccm
   Débit d'oxygène (D_{R}2) : 15 sccm
   Pression régnant dans l'enceinte : 10 Pa
   Temps d'oxydation-cristallisation : 5 min pour chaque couche, soit un temps de cristallisation-oxydation cumulé de 15 min pour les 3 couches.

La figure 3A illustre les courbes de pression en Pa (courbe P), de courant en A (courbe C) et de température en °C (courbe T) en fonction du temps, noté t et exprimé en min, telles que relevées sur les 250 min suivant le démarrage du chauffage du substrat (qui correspond au point 0 de l'axe des abscisses). Il est à noter que, comme le montre cette figure, le chauffage du substrat a été arrêté et la pression régnant dans la chambre de pulvérisation ramenée à 1 Pa à l'issue du troisième cycle de traitement.

La figure 3B est un agrandissement de la partie située entre les pointillés sur la figure 3A, qui montre les courbes de pression en Pa (courbe P), de débit d'argon en sccm (courbe D_{P}) et de débit d'oxygène en sccm (courbe D_{R}) en fonction du temps, exprimé en minutes, telles que relevées sur cette zone. Sur cette figure, la chute de pression visible dans le cercle en pointillés correspond à une consommation de l'oxygène par le film métallique préalablement déposé et prouve que le film métallique est en cours d'oxydation

Les films ainsi fabriqués sont soumis à des examens au microscope électronique à balayage et les images obtenues ont comparées à celles obtenues pour des films d'YSZ ayant été fabriqués en utilisant les mêmes types de substrats mais en procédant à un dépôt conventionnel par pulvérisation magnétron. Ce dépôt conventionnel a été réalisé dans les conditions de pulvérisation élémentaire suivantes :
Température au niveau du porte substrat : non contrôlée et < 200 °C
Distance entre la cible et le substrat : 127 mm
Intensité du courant de décharge sur la cible : 1,25 A
Tension de la décharge sur la cible : ≈ - 230 V
Pulses : 5 µs à 50 kHz
Débit d'argon : 20 sccm
Débit d'oxygène : 3 sccm
Pression régnant dans l'enceinte : 1 Pa
Temps de dépôt : 60 min.

Les images MEB des films fabriqués par le procédé de l'invention sont illustrées sur les figures 4A et 4B d'une part, et 6A et 6B d'autre part, tandis que les images MEB des films fabriqués par le dépôt conventionnel sont illustrées sur les figures 5A et 5B d'une part, et 7A et 7B d'autre part.

Comme le montrent ces figures, une structure colonnaire continue sur toute l'épaisseur est observée pour les films fabriqués par le dépôt conventionnel, tandis que, dans le cas des films fabriqués par le procédé de l'invention, les étapes dépôt/oxydation-cristallisation peuvent clairement être distinguées (cf. figures 4A et 4B).

De plus, les films fabriqués par le procédé de l'invention présentent une structure cristallisée avec la présence de nombreuses facettes (cf. notamment la figure 6B) que l'on ne retrouve pas dans les films fabriqués par le dépôt conventionnel.

Par ailleurs, la perméabilité aux gaz des films est appréciée par un test de perméabilité à l'azote consistant à imposer une différence de pression initiale de 3.10⁴ Pa (300 mbar) entre les côtés anodique et cathodique de cellules électrochimiques mesurant 60 mm de diamètre et ayant pour électrolyte l'un de ces films et à mesurer la chute de pression dans le temps.

Les résultats de ce test sont illustrés sur la figure 8 qui présente le taux de fuite, noté Q et exprimé en hPa.L/s, tel qu'obtenu pour deux films d'YSZ mesurant chacun 1,75 µm d'épaisseur : un film ayant été fabriqué par le procédé de l'invention (bâton de droite) et un film ayant été fabriqué par le dépôt conventionnel (bâton de gauche).

Comme visible sur cette figure, le taux de fuite est de 10⁻² hPa.L/s pour le film ayant été fabriqué par le dépôt conventionnel alors que ce taux de fuite n'est que de 6,66.10⁻⁴ hPa.L/s pour le film ayant été fabriqué par le procédé de l'invention.

Le taux de fuite obtenu pour le film ayant été fabriqué par le procédé de l'invention est proche de celui que présente typiquement un film d'électrolyte de YSZ pour SOC de 8 µm d'épaisseur obtenu par sérigraphie (10⁻⁴ hPa.L/s).

### II.2 - Mise en évidence de l'influence du nombre de cycles sur le degré d'oxydation-cristallisation des films :

Compte-tenu que la transmission optique d'un film est caractéristique de son degré d'oxydation-cristallisation, on mesure la transmission optique entre 350 nm et 1000 nm de films d'YSZ ayant été fabriqués par le procédé de l'invention comme décrit au point II ci-avant mais en soumettant les substrats à 2, 3 ou 4 cycles de traitement.

À titre de comparaison, on mesure également la transmission optique dans la même gamme de longueurs d'onde :
- d'un film d'YSZ ayant été fabriqué par un dépôt conventionnel par pulvérisation magnétron tel que décrit au point II.1 ci-avant,
- d'un film d'YSZ ayant été fabriqué par un procédé se différenciant du procédé de l'invention en ce qu'il ne comprend qu'un seul cycle de traitement, et
- d'un film d'YSZ totalement oxydé, ce film ayant été fabriqué par un procédé se différenciant du procédé de l'invention en ce qu'il ne comprend qu'un seul cycle de traitement, puis ayant été traité thermiquement dans un four sous air à 500 °C pendant 1 min.

Les résultats de ces mesures sont montrés sur la figure 9 qui illustre l'évolution de la transmission optique, notée R et exprimée en %, en fonction de la longueur d'onde, notée λ et exprimée en nm. Sur cette figure, la courbe A correspond au film ayant été fabriqué par le dépôt conventionnel ; la courbe B correspond au film ayant été fabriqué par le procédé ne comprenant qu'un cycle de traitement; les courbes C, D et E correspondent aux films ayant été fabriqués par le procédé de l'invention, tandis que la courbe F correspond au film totalement oxydé.

Comme le montre cette figure, la transmission optique et, partant, le degré d'oxydation-cristallisation des films ayant été préparés par le procédé de l'invention (courbes C, D et E) est bien supérieure à celle du film ayant été fabriqué par le procédé ne comprenant qu'un cycle de traitement (courbe B) qui elle, même est bien supérieure à celle du film ayant été fabriqué par le dépôt conventionnel (courbe A).

Par ailleurs, la transmission optique et, partant, le degré d'oxydation-cristallisation des films ayant été fabriqués par le procédé de l'invention augmente avec le nombre de cycles de traitement mis en œuvre dans ce procédé.

Il est donc possible de conférer à un film d'électrolyte la stoechiométrie en oxygène et/ou le degré d'oxydation désirés en jouant sur le nombre de cycles de traitement mis en œuvre dans le procédé de l'invention tout comme il est possible d'adapter le nombre de cycles de traitement en fonction de la tendance que peut avoir le matériau constituant ce film à délaminer.

### RÉFÉRENCES CITÉES

**[1]** E.S. Thiele, L.S. Wang, T.O. Mason, S.A. Barnett, Journal of Vacuum Science and Technology A 9 (6), 1991, 3054-3060
**[2]** A.F. Jankowski, J.P. Hayes, Surface and Coatings Technology 76-77, 1995, 126-131
**[3]** R.W. Knoll, E.R. Bradley, Thin Solid Films 117, 1984, 201-210
**[4]** A.L. Shaula, J.C. Oliveira, V.A. Kolotygin, C. Louro, V.V. Kharton, A. Cavaleiro, Vacuum 83, 2009, 1266-1269
**[5]** P. Plantin, A.L. Thomann, P. Brault, B. Dumax, J. Mathias, T. Sauvage, A. Pineau, Surface & Coatings Technology 200, 2005, 408-412
**[6]** N.D. Pilling, R.E. Bedworth, Journal Institute of Metals 29, 1923, 529
**[7]** Y.I. Park, Y. Saito, R. Pornprasertsuk, J. Cheng, S.W. Cha, F.B. Prinz, in: S.C. Singhal, M. Dokiya (EDs.), ECS Proc. SOFC VIII, 7, 2003, 169
**[8]** C.Y. Ma, P. Briois, J. Bohlmark, F. Lapostolle, A. Billard, Ionics 14, 2008, 471
**[9]** P. Coddet, M.C. Pera, A. Billard, Fuel Cells, 11(2), 2011, 158-164
[10] H. HIDALGO ET AL: "Optimization of DC Reactive Magnetron Sputtering Déposition Process for Efficient YSZ Electrolyte Thin Film SOFC", FUEL CELLS, vol. 13, no. 2,1 avril 2013 (2013-04-01), pages 279-288

## Revendications

1. Procédé de fabrication d'un électrolyte sous la forme d'un film pour cellules électrochimiques à oxyde solide, **caractérisé en ce qu'**il comprend les étapes consistant à :
- chauffer un substrat à une température allant de 200 °C à 1 200 °C ; puis
- soumettre le substrat à au moins deux cycles de traitement, chaque cycle de traitement comprenant :
1) un dépôt d'une couche d'un précurseur métallique sur le substrat par pulvérisation cathodique magnétron d'une cible constituée du précurseur métallique, la pulvérisation étant réalisée dans des conditions de pulvérisation élémentaire ; puis
2) une oxydation-cristallisation du précurseur métallique formant la couche déposée sur le substrat en présence d'oxygène pour obtenir la transformation du précurseur métallique en le matériau d'électrolyte ;
et **en ce que** le substrat est maintenu à une température allant de 200°C à 1 200°C pendant toute la durée de chaque cycle de traitement.

2. Procédé selon la revendication 1, **caractérisé en ce que** le substrat est chauffé et maintenu à une température allant de 450 °C à 850 °C pendant toute la durée de chaque cycle de traitement.

3. Procédé selon la revendication 1 ou la revendication 2, **caractérisé en ce que** chaque cycle de traitement est réalisé dans une chambre de pulvérisation cathodique magnétron dans laquelle se trouvent le substrat chauffé et la cible et dans laquelle règne une pression, et **en ce que** chaque cycle de traitement comprend les étapes consistant à :
- alimenter la chambre de pulvérisation en un gaz plasmagène à un débit D_{P}1 ;
- ajuster la pression régnant dans la chambre de pulvérisation à une valeur allant de 0,1 Pa à 10 Pa ;
- débuter la pulvérisation de la cible ;
- alimenter la chambre de pulvérisation en oxygène à un débit D_{R}1 inférieur au débit D_{P}1 tout en maintenant la pression régnant dans la chambre de pulvérisation à la valeur allant de 0,1 Pa à 10 Pa, pour créer des conditions de pulvérisation élémentaire ;
- maintenir les conditions de pulvérisation élémentaire pendant un temps suffisant pour obtenir la formation de la couche du précurseur métallique sur le substrat ;
- arrêter la pulvérisation de la cible ;
- augmenter le débit D_{R}1 pour obtenir un débit d'alimentation de la chambre de pulvérisation en oxygène D_{R}2, arrêter l'alimentation de la chambre de pulvérisation en gaz plasmagène ou réduire le débit D_{P}1 pour obtenir un débit d'alimentation de la chambre de pulvérisation en gaz plasmagène Dp2 au plus égal à 1/2 de D_{R}2 et ajuster la pression régnant dans la chambre de pulvérisation à une valeur au moins égale à 10 Pa, pour créer des conditions d'oxydation-cristallisation du précurseur métallique formant la couche déposée sur le substrat ;
- maintenir les conditions d'oxydation-cristallisation pendant un temps suffisant pour obtenir la transformation du précurseur métallique formant la couche déposée sur le substrat en le matériau d'électrolyte par oxydation-cristallisation du précurseur métallique ; et
- arrêter l'alimentation de la chambre de pulvérisation en oxygène.

4. Procédé selon la revendication 3, **caractérisé en ce que** le substrat est maintenu à une température constante pendant toute la durée de chaque cycle de traitement.

5. Procédé selon la revendication 3 ou la revendication 4, **caractérisé en ce que** le débit D_{P}1 est compris entre 1 sccm et 500 sccm.

6. Procédé selon l'une quelconque des revendications 3 à 5, **caractérisé en ce que** le débit D_{R}1 est au plus égal à 100 sccm.

7. Procédé selon l'une quelconque des revendications 3 à 6, **caractérisé en ce que** le débit D_{R}2 est compris entre 10 sccm à 500 sccm.

8. Procédé selon l'une quelconque des revendications 3 à 7, **caractérisé en ce que** :
- les conditions de pulvérisation élémentaire sont maintenues durant 1 minute à 120 minutes, et/ou
- les conditions d'oxydation-cristallisation sont maintenues durant 1 minute à 60 minutes.

9. Procédé selon la revendication 1 ou la revendication 2, **caractérisé en ce que** chaque cycle de traitement est réalisé dans deux chambres différentes, le dépôt étant réalisé dans une première chambre qui est une chambre de pulvérisation cathodique magnétron dans laquelle règnent des conditions de pulvérisation élémentaire, et l'oxydation-cristallisation étant réalisée dans une deuxième chambre dans laquelle règnent des conditions d'oxydation-cristallisation, et **en ce que** chaque cycle de traitement comprend de plus le transfert du substrat de la première chambre à la deuxième chambre.

10. Procédé selon la revendication 9, **caractérisé en ce que** les conditions de pulvérisation élémentaire comprennent une pression régnant dans la première chambre comprise entre 0,1 Pa et 10 Pa, une alimentation de la première chambre en un gaz plasmagène à un débit D_{P}1 et une alimentation de la première chambre en oxygène à un débit D_{R}1 inférieur au débit D_{P}1, et **en ce que** les conditions d'oxydation-cristallisation comprennent une pression régnant dans la deuxième chambre au moins égale à 10 Pa et une alimentation de la deuxième chambre en oxygène à un débit D_{R}2 supérieur au débit D_{R}1.

11. Procédé selon la revendication 10, **caractérisé en ce que** le débit D_{P}1 est compris entre 1 sccm et 500 sccm.

12. Procédé selon la revendication 10 ou la revendication 11, **caractérisé en ce que** :
- le débit D_{R}1 est au plus égal à 100 sccm, et/ou
- le débit D_{R}2 est compris entre 10 sccm à 500 sccm.

13. Procédé selon l'une quelconque des revendications 9 à 12, **caractérisé en ce que** :
- le substrat est maintenu dans la première chambre durant 1 minute à 120 minutes, et/ou
- le substrat est maintenu dans la deuxième chambre durant 1 minute à 60 minutes et, mieux encore, durant 1 minute à 5 minutes.

14. Procédé selon l'une quelconque des revendications 1 à 13, **caractérisé en ce qu'**il comprend de 2 à 20 cycles de traitement.

15. Procédé selon l'une quelconque des revendications 1 à 14, **caractérisé en ce que** la cible comprend un mélange M-M' dans lequel M représente le zirconium ou le cérium et M' représente l'yttrium, le scandium ou un lanthanide, de préférence un mélange de zirconium et d'yttrium.

## Patentansprüche

1. Verfahren zur Herstellung eines Elektrolyten in Form eines Films für elektrochemische Festoxidzellen, **dadurch gekennzeichnet, dass** es die folgenden Schritte umfasst:
- Erhitzen eines Substrats auf eine Temperatur im Bereich von 200 °C bis 1200 °C; dann
- Unterziehen des Substrats mindestens zwei Behandlungszyklen, wobei jeder Behandlungszyklus umfasst:
1) Abscheiden einer Schicht eines metallischen Vorläufers auf dem Substrat durch Magnetron-Sputtern eines Targets, das aus dem metallischen Vorläufer besteht, wobei das Sputtern unter Bedingungen für elementare Zerstäubung durchgeführt wird; dann
2) Oxidations-Kristallisation des metallischen Vorläufers, der die auf dem Substrat abgeschiedene Schicht bildet, in Gegenwart von Sauerstoff zum Umwandeln des metallischen Vorläufers in das Elektrolytmaterial;
und dadurch, dass das Substrat während der gesamten Dauer jedes Behandlungszyklus auf einer Temperatur von 200 °C bis 1200 °C gehalten wird.

2. Verfahren nach Anspruch 1, **dadurch gekennzeichnet, dass** das Substrat auf eine Temperatur von 450 °C bis 850 °C erhitzt und während der gesamten Dauer jedes Behandlungszyklus auf dieser gehalten wird.

3. Verfahren nach Anspruch 1 oder Anspruch 2, **dadurch gekennzeichnet, dass** jeder Behandlungszyklus in einer Magnetron-Sputterkammer durchgeführt wird, in der sich das erhitzte Substrat und das Target befinden und in der ein Druck herrscht, und dass jeder Behandlungszyklus die folgenden Schritte umfasst:
- Zuführen von Plasmagas in die Sputterkammer mit einer Zufuhrrate D_{P}1;
- Einstellen des in der Sputterkammer herrschenden Drucks auf einen Wert im Bereich von 0,1 Pa bis 10 Pa;
- Starten des Sputterns des Targets;
- Zuführen von Sauerstoff in die Sputterkammer mit einer Zufuhrrate D_{R}1, die niedriger ist als die Zufuhrrate D_{P}1, während der in der Sputterkammer herrschende Druck auf einem Wert von 0,1 Pa bis 10 Pa gehalten wird, um Bedingungen für elementare Zerstäubung zu schaffen;
- Aufrechterhaltung der Bedingungen für elementare Zerstäubung für eine Zeit, die ausreicht, um die Bildung der Schicht des metallischen Vorläufers auf dem Substrat zu erreichen;
- Anhalten des Sputterns des Targets;
- Erhöhen der Zufuhrrate D_{R}1, um eine Sauerstoff-Zufuhrrate D_{R}2 zur Sputterkammer zu erreichen, Anhalten der Zufuhr von Plasmagas zur Sputterkammer oder Reduzieren der Zufuhrrate D_{P}1, um eine Plasmagas-Zufuhrrate D_{P}2 zur Sputterkammer zu erreichen, die höchstens gleich 1/2 von D_{R}2 ist, und Einstellen des in der Sputterkammer herrschenden Drucks auf einen Wert von mindestens gleich 10 Pa, um Oxidations-Kristallisations-Bedingungen für den metallischen Vorläufer zum Bilden der auf dem Substrat abgeschiedenen Schicht zu schaffen;
- Aufrechterhalten der Oxidations-Kristallisations-Bedingungen für eine Zeit, die ausreicht, um die Umwandlung des metallischen Vorläufers, der die auf dem Substrat abgeschiedene Schicht bildet, in das Elektrolytmaterial durch Oxidations-Kristallisation des metallischen Vorläufers zu erreichen; und
- Anhalten der Sauerstoffzufuhr in die Sputterkammer.

4. Verfahren nach Anspruch 3, **dadurch gekennzeichnet, dass** das Substrat während der gesamten Dauer jedes Behandlungszyklus auf einer konstanten Temperatur gehalten wird.

5. Verfahren nach Anspruch 3 oder Anspruch 4, **dadurch gekennzeichnet, dass** die Zufuhrrate D_{P}1 zwischen 1 sccm und 500 sccm liegt.

6. Verfahren nach einem der Ansprüche 3 bis 5, **dadurch gekennzeichnet, dass** die Zufuhrrate D_{R}1 höchstens gleich 100 sccm ist.

7. Verfahren nach einem der Ansprüche 3 bis 6, **dadurch gekennzeichnet, dass** die Zufuhrrate D_{R}2 zwischen 10 sccm und 500 sccm liegt.

8. Verfahren nach einem der Ansprüche 3 bis 7, **dadurch gekennzeichnet, dass**
- die Bedingungen für elementare Zerstäubung für 1 Minute bis 120 Minuten aufrechterhalten werden, und/oder
- die Oxidations-Kristallisations-Bedingungen für 1 Minute bis 60 Minuten aufrechterhalten werden.

9. Verfahren nach Anspruch 1 oder Anspruch 2, **dadurch gekennzeichnet, dass** jeder Behandlungszyklus in zwei verschiedenen Kammern durchgeführt wird, wobei die Abscheidung in einer ersten Kammer durchgeführt wird, die eine Magnetron-Sputterkammer ist, in der Bedingungen für elementare Zerstäubung vorherrschen, und die Oxidations-Kristallisation in einer zweiten Kammer durchgeführt wird, in der Oxidations-Kristallisations-Bedingungen vorherrschen, und dass jeder Behandlungszyklus ferner den Transfer des Substrats von der ersten Kammer in die zweite Kammer umfasst.

10. Verfahren nach Anspruch 9, **dadurch gekennzeichnet, dass** die Bedingungen für elementare Zerstäubung einen in der ersten Kammer herrschenden Druck zwischen 0,1 Pa und 10 Pa, eine Zufuhr von Plasmagas in die erste Kammer mit einer Zufuhrrate D_{P}1 und eine Zufuhr von Sauerstoff in die erste Kammer mit einer Zufuhrrate D_{R}1, die kleiner als die Zufuhrrate D_{P}1 ist, umfassen, und dass die Oxidations-Kristallisations-Bedingungen einen in der zweiten Kammer herrschenden Druck, der mindestens gleich 10 Pa ist, und eine Zufuhr von Sauerstoff in die zweite Kammer mit einer Zufuhrrate D_{R}2, die größer als die Zufuhrrate D_{R}1 ist, umfassen.

11. Verfahren nach Anspruch 10, **dadurch gekennzeichnet, dass** die Zufuhrrate D_{P}1 zwischen 1 sccm und 500 sccm liegt.

12. Verfahren nach Anspruch 10 oder Anspruch 11, **dadurch gekennzeichnet, dass**
- die Zufuhrrate D_{R}1 höchstens gleich 100 sccm ist, und/oder
- die Zufuhrrate D_{R}2 zwischen 10 sccm und 500 sccm liegt.

13. Verfahren nach einem der Ansprüche 9 bis 12, **dadurch gekennzeichnet, dass**
- das Substrat für 1 Minute bis 120 Minuten in der ersten Kammer gehalten wird, und/oder
- das Substrat für 1 Minute bis 60 Minuten und vorzugsweise für 1 Minute bis 5 Minuten in der zweiten Kammer gehalten wird.

14. Verfahren nach einem der Ansprüche 1 bis 13, **dadurch gekennzeichnet, dass** es 2 bis 20 Behandlungszyklen umfasst.

15. Verfahren nach einem der Ansprüche 1 bis 14, **dadurch gekennzeichnet, dass** das Target ein Gemisch M-M' umfasst, wobei M für Zirkonium oder Cer und M' für Yttrium, Scandium oder ein Lanthanid, vorzugsweise für ein Gemisch aus Zirkonium und Yttrium, steht.

## Claims

1. Method for manufacturing an electrolyte in the form of a film for solid oxide electrochemical cells, **characterised in that** it comprises the steps of:
- heating a substrate to a temperature ranging from 200 °C to 1,200 °C; then
- subjecting the substrate to at least two treatment cycles, each treatment cycle comprising:
1) depositing one layer of a metal precursor on the substrate by magnetron cathode sputtering of a target consisting of the metal precursor, the sputtering being carried out under elemental sputtering conditions; then
2) oxidation-crystallisation of the metal precursor forming the layer deposited on the substrate in the presence of oxygen to obtain the transformation of the metal precursor into the electrolyte material;
and **in that** the substrate is kept at a temperature ranging from 200°C to 1,200°C for the entire duration of each treatment cycle.

2. Method according to claim 1, **characterised in that** the substrate is heated and kept at a temperature ranging from 450 °C to 850 °C for the entire duration of each treatment cycle.

3. Method according to claim 1 or claim 2, **characterised in that** each treatment cycle is carried out in a magnetron cathodic sputtering chamber in which the heated substrate and the target are located and in which a pressure prevails, and **in that** each treatment cycle comprises the steps of:
- supplying the sputtering chamber with a plasma gas at a flow rate D_{P}1;
- adjusting the pressure prevailing in the sputtering chamber to a value ranging from 0.1 Pa to 10 Pa;
- starting the sputtering of the target;
- supplying the sputtering chamber with oxygen at a flow rate D_{R}1 lower than the flow rate D_{P}1 while keeping the pressure prevailing in the sputtering chamber at the value ranging from 0.1 Pa to 10 Pa, in order to create elemental sputtering conditions;
- keeping the elemental sputtering conditions for a time sufficient to obtain the formation of the layer of the metal precursor on the substrate;
- stopping the sputtering of the target;
- increasing the flow rate D_{R}1 to obtain a supply flow rate of the sputtering chamber with oxygen D_{R}2, stopping the supplying of the sputtering chamber with plasma gas or reducing the flow rate D_{P}1 to obtain a supply flow rate of the sputtering chamber with plasma gas D_{P}2 at most equal to 1/2 of D_{R}2 and adjusting the pressure prevailing in the sputtering chamber to a value at least equal to 10 Pa, to create oxidation-crystallisation conditions of the metal precursor forming the layer deposited on the substrate;
- keeping the oxidation-crystallisation conditions for a time sufficient to obtain the transformation of the metal precursor forming the layer deposited on the substrate into the electrolyte material by oxidation-crystallisation of the metal precursor; and
- stopping the supplying of the sputtering chamber with oxygen.

4. Method according to claim 3, **characterised in that** the substrate is kept at a constant temperature for the entire duration of each treatment cycle.

5. Method according to claim 3 or claim 4, **characterised in that** the flow rate D_{P}1 is comprised between 1 sccm and 500 sccm.

6. Method according to any of claims 3 to 5, **characterised in that** the flow rate D_{R}1 is at most equal to 100 sccm.

7. Method according to any of claims 3 to 6, **characterised in that** the flow rate D_{R}2 is comprised between 10 sccm to 500 sccm.

8. Method according to any of claims 3 to 7, **characterised in that**:
- the elemental sputtering conditions are kept for 1 minute to 120 minutes, and/or
- the oxidation-crystallisation conditions are kept for 1 minute to 60 minutes.

9. Method according to claim 1 or claim 2, **characterised in that** each treatment cycle is carried out in two different chambers, the depositing being carried out in a first chamber which is a magnetron cathodic sputtering chamber in which elemental sputtering conditions prevail, and the oxidation-crystallisation being carried out in a second chamber in which oxidation-crystallisation conditions prevail, and **in that** each treatment cycle comprises in addition the transfer of the substrate from the first chamber to the second chamber.

10. Method according to claim 9, **characterised in that** the elemental sputtering conditions comprise a pressure prevailing in the first chamber comprised between 0.1 Pa and 10 Pa, a supplying of the first chamber with a plasma gas at a flow rate D_{P}1 and a supplying of the first chamber with oxygen at a flow rate D_{R}1 lower than the flow rate D_{P}1, and **in that** the oxidation-crystallisation conditions comprise a pressure prevailing in the second chamber at least equal to 10 Pa and a supplying of the second chamber with oxygen at a flow rate D_{R}2 greater than the flow rate D_{R}1.

11. Method according to claim 10, **characterised in that** the flow rate D_{P}1 is comprised between 1 sccm and 500 sccm.

12. Method according to claim 10 or claim 11, **characterised in that**:
- the flow rate D_{R}1 is at most equal to 100 sccm, and/or
- the flow rate D_{R}2 is comprised between 10 sccm to 500 sccm.

13. Method according to any of claims 9 to 12, **characterised in that**:
- the substrate is kept in the first chamber for 1 minute to 120 minutes, and/or
- the substrate is kept in the second chamber for 1 minute to 60 minutes and, even better, for 1 minute to 5 minutes.

14. Method according to any of claims 1 to 13, **characterised in that** it comprises from 2 to 20 treatment cycles.

15. Method according to any of claims 1 to 14, **characterised in that** the target comprises a mixture M-M' wherein M represents zirconium or cerium and M' represents yttrium, scandium or a lanthanide, preferably a mixture of zirconium and yttrium.
